# FASCICULE DE BREVET EUROPEEN

(11) **EP 2 334 160 B1**
(45) Date de publication et mention de la délivrance du brevet: **29.05.2013**
(21) Numéro de dépôt: 10193375.2
(22) Date de dépôt: 01.12.2010
(51) Int. Cl.: H05K 7/14

(54) **Glissière pour carte électronique**
Kartenlesegeräteschlitz zum Durchziehen von elektronischen Karten
Slide for an electronic card

(30) Priorité: 01.12.2009 FR 0958564
(43) Date de publication de la demande: 15.06.2011
(73) Titulaire: Airbus Operations, 31060 Toulouse (FR)
(72) Inventeur: Colongo, Emile, 31310, Montesquieu Volvestre (FR); Roujean, Olivier, 31200, Toulouse (FR)
(74) Mandataire: Petit, Maxime

(56) Documents cités:
- EP-A1- 1 786 252
- US-A- 4 157 583
- US-A- 5 003 431
- US-A- 5 200 882
- US-A- 5 224 016

## Description

La présente invention concerne d'une manière générale les glissières pour cartes électroniques destinées à être montées dans une rainure d'un socle pour carte électronique.

Dans ce type d'agencement, chaque carte électronique ou module électronique est monté, suivant l'une de ses tranches, sur une glissière. La glissière est elle-même insérée dans une rainure prévue à cet effet dans le socle d'un boitier ou cabinet pour cartes électroniques. Le fond du boitier présente une pluralité de connecteurs disposée perpendiculairement au socle, de manière à raccorder électriquement les cartes électroniques montées sur la glissière par une tranche perpendiculaire et immédiatement voisine de la tranche montée sur la glissière. La glissière permet de verrouiller la carte une fois insérée dans la rainure.

Plus particulièrement, la présente invention concerne le verrouillage, le déverrouillage et l'extraction de telles glissières portant les cartes.

La présente invention s'applique notamment aux cabinets de cartes électroniques de dispositifs avioniques d'un aéronef.

D'une manière générale, dans le domaine des glissières pour cartes électroniques, les cartes électroniques sont fixées, en général par vissage, sur une glissière qui présente des moyens de fixation de la glissière dans la rainure correspondante. La fixation dans la rainure assure d'une part une fonction mécanique permettant de maintenir la carte immobile par rapport au connecteur une fois enfichée dans celui-ci, permettant de verrouiller la carte dans son socle. D'autre part, une fonction la fixation dans la rainure assure une fonction thermique. En effet, dans les équipements électroniques soumis à des conditions d'utilisation difficiles, notamment à des températures élevées, il est nécessaire d'assurer le refroidissement des composants en utilisant notamment des drains thermiques de ces composants vers des sources froides. Dans le cas des cartes montées sur glissière, une source froide potentielle non négligeable est le socle. Les drains thermiques peuvent alors être optimisés entre les composants électroniques de la carte et le socle via la glissière.

On comprendra donc que pour assurer un bon fonctionnement des cartes électroniques dans leur boitier, il est nécessaire de prévoir une fixation dans la rainure permettant, d'une part, un bon maintien mécanique et, d'autre part, une transmission thermique satisfaisante.

On connaît du document US 5 200 882 une glissière de ce type, permettant de verrouiller une carte électronique dans une rainure de socle.

La glissière comporte une paroi élastique mobile sur laquelle vient appuyer un arbre central à profil de came. Une rotation de 90° de l'arbre permet d'écarter la paroi mobile de manière à pousser la paroi mobile contre une paroi de la rainure, pour serrer ainsi la carte contre la paroi opposée de la rainure.

Par ailleurs, l'évolution des besoins dans le domaine électronique entraine une augmentation significative du nombre de contacts électriques entre la carte et le connecteur pour véhiculer un plus grand nombre de signaux. Ceci a conduit les concepteurs des connecteurs pour cartes électroniques à accroître la densité des points de connexion sur ces derniers.

Or, pour assurer un bon contact électrique, il est nécessaire de prévoir une pression superficielle entre la carte et le contact.

Cette pression se traduit par une force de rétention donnée pour un contact, ce qui, à l'échelle de la carte toute entière peut exiger une force importante pour son insertion ou son extraction du connecteur.

Ainsi, par exemple, un connecteur classique nécessite une force de 0,7N par contact. Une carte électronique pouvant comporter jusqu'à 500 contacts, une force 350N est nécessaire pour insérer ou extraire la carte. Cette valeur est rédhibitoire dans certaines conditions, notamment lorsque l'accessibilité est réduite, et peut donc interdire le montage ou le démontage.

Pour pallier à cela, il a été proposé d'ajouter un extracteur, par exemple sur la carte ou sur la glissière. En général, ce type d'extracteur est un levier monté à rotation par rapport à la carte ou la glissière et dont l'extrémité vient en appui sur le socle pour extraire la carte.

On connaît de l'état de la technique, un type de glissière dans lequel on combine les moyens de verrouillage à paroi mobile et arbre à profil de came avec un extracteur à levier monté en bout de glissière.

Ce type de glissière permet de verrouiller, déverrouiller et extraire les cartes de leur socle et de leur connecteur respectif, tout en assurant une bonne transmission thermique.

Cependant, ce type de glissière présente plusieurs inconvénients.

Pour démonter la carte, dans un premier temps, l'opérateur doit avoir recours à un outil pour faire tourne l'arbre afin de déverrouiller la glissière. En général, il s'agit d'un outil spécifique de type tournevis avec un embout adapté à l'arbre. Ensuite seulement, le levier d'extraction peut être activé.

La conception de ce type de glissière implique de prévoir de la place pour le passage du tournevis. Cette place ne doit pas être encombrée par le levier, qui doit rester fonctionnel par ailleurs. Par ailleurs, la glissière présente un nombre important de pièces, pour le dispositif de verrouillage, d'une part, et pour le dispositif d'extraction, d'autre part, ce qui entraine un coût et un poids importants.

Le document US 4 157 583 décrit un dispositif de maintien d'une carte électronique dans une boîte de montage. Le dispositif comprend un arbre à came relié au cadre de la carte électronique par l'intermédiaire d'éléments de support qu'il traverse. Un levier fixé à une extrémité de l'arbre permet de faire pivoter ce dernier sur lui-même et d'exercer, par l'intermédiaire de la came de l'arbre, une pression sur les éléments de support de la carte pour la maintenir en place dans le boîtier.

Le document EP 1 786 252 décrit un dispositif et une méthode pour insérer ou extraire un module enfichable. Le dispositif comprend un levier disposant d'une poignée pour faire pivoter le levier autour d'un axe, un élément de verrouillage par encliquetage qui est apte à verrouiller le levier dans une position pivotée et un élément de déverrouillage associé.

Fondée sur ces observations, la présente invention a pour objet d'une manière générale de perfectionner les glissières existantes. Plus particulièrement, la présente invention a pour objet de proposer une glissière plus commode d'emploi, et permettant de retirer les cartes rapidement et sans effort, tout en étant simple et économique.

L'invention propose à cet effet une glissière pour carte électronique destinée à être montée dans une rainure d'un socle pour carte électronique, comportant un levier d'extraction de glissière monté en rotation sur la glissière autour d'un premier axe sensiblement parallèle à la direction longitudinale de la glissière et en rotation autour d'un second axe sensiblement perpendiculaire au premier axe, le levier comportant :
- une extrémité de manipulation et, à son extrémité opposée,
- une extrémité d'appui présentant un moyen d'appui sur le socle, les deux extrémités étant disposées de part et d'autre du second axe de rotation,
- un moyen de commande mécanique disposé de manière à ce que, lorsque la glissière est montée dans le socle, et que le levier est entraîné en pivotement par son extrémité de manipulation autour du premier axe, le moyen de commande impose au levier une rotation autour du second axe de manière à éloigner l'extrémité de manipulation du socle et à rapprocher l'extrémité d'appui du socle afin que cette extrémité prenne appui sur le socle et, par son mouvement de rapprochement contribue à dégager la glissière du socle.

Ainsi, il suffit à l'opérateur de faire pivoter le levier d'extraction pour amorcer l'extraction de la carte électronique, ce qui permet de retirer les cartes plus facilement et simplifie la maintenance des boitiers électroniques.

L'extraction se poursuit de manière conventionnelle, en tirant sur l'extrémité de manipulation par appui sur le socle, l'extrémité d'appui permettant d'extraire la carte par rotation du levier autour du second axe.

Selon une caractéristique avantageuse de l'invention, le premier axe de rotation est matérialisé par un arbre présentant un profil de came monté longitudinalement dans la glissière, la glissière présentant une face longitudinale mobile destinée à coopérer avec le profil de came de l'arbre de manière à ce que, lorsque la glissière est montée dans le socle, le profil de came écarte la face longitudinale mobile de façon à verrouiller la glissière dans la rainure du socle dans laquelle elle est montée et, lors d'une rotation du levier autour du premier axe, l'arbre tourne sur lui-même de manière à dégager le profil de came et libérer la face mobile pour déverrouiller la glissière dans la rainure.

Ainsi, avantageusement, la glissière selon l'invention rassemble les fonctions de déverrouillage et d'amorce d'extraction en un seul levier et en une seule manipulation. En effet, il suffit à l'opérateur de faire pivoter le levier autour du premier axe pour, d'une part, déverrouiller la glissière et, d'autre part, amorcer l'extraction de la glissière via le moyen de commande et le second axe de rotation.

Les fonctions de déverrouillage et d'extraction sont réunies en un seul levier ce qui permet un gain de place, et un meilleur agencement de la glissière. L'espace disponible pour la surface de la carte électronique et donc pour le nombre de composants que l'on peut y placer s'en trouve augmenté. Le nombre de pièces constitutives de la glissière est réduit, ce qui a une influence avantageuse sur le coût et le poids de l'ensemble. Aucun outil n'est nécessaire, et l'extraction de la carte peut se faire d'une seule main et d'un seul geste, ce qui permet de minimiser les temps de maintenance.

Selon des caractéristiques préférées, pour des raisons de fiabilité et de commodité, éventuellement combinées :
- le moyen de commande comporte entre le levier et la glissière une surface inclinée formant rampe et un doigt de commande glissant sur ladite surface de manière à imposer au levier ladite rotation autour du second axe afin d'éloigner l'extrémité de manipulation du socle lorsque le levier est entraîné en pivotement par son extrémité de manipulation autour du premier axe;
- la glissière présente une face avant en regard du levier, la rampe étant disposée sur ladite face, le doigt étant disposé sur le levier sensiblement en regard de cette face, et la rampe étant circulaire de manière à se trouver sur le chemin du doigt lorsque le levier est entraîné en pivotement autour du premier axe;
- la face avant de la glissière est inclinée par rapport à la direction longitudinale de la glissière de manière à constituer ladite surface inclinée formant rampe;
- le levier d'extraction est coudé pour s'éloigner de la carte à son extrémité de manipulation de manière à se trouver dégagé de la carte voisine sur le socle lorsqu'il a pivoté;
- le moyen de commande comporte une surface en profil de came disposée sur le socle et un doigt de commande disposé sur le levier, le doigt glissant sur ladite surface de manière à imposer au levier ladite rotation autour du second axe de manière à éloigner l'extrémité de manipulation du socle lorsque le levier est entraîné en pivotement par son extrémité de manipulation autour du premier axe;
- le doigt de commande est l'extrémité d'appui du levier.

L'invention vise en outre, selon un autre aspect, un socle pour une carte électronique montée sur une glissière telle que décrite supra.

L'invention vise en outre, selon un autre aspect, un aéronef comportant un boitier de cartes électroniques comportant au moins une glissière telle que décrite supra.

L'exposé de l'invention sera maintenant poursuivi par la description détaillée d'un exemple de réalisation, donnée ci-après à titre illustratif et non limitatif, en référence aux dessins annexés. Sur ceux-ci :
- la figure 1 est une vue en perspective d'une carte électronique montée sur une glissière selon l'invention, elle-même montée dans une rainure d'un socle pour carte électronique ;
- la figure 2A est une vue en perspective d'une glissière selon l'invention ;
- la figure 2B est une vue éclatée de la glissière de la figure 2A ;
- la figure 3 est une vue de détail de la glissière des figures 2A et 2B;
- la figure 4 est une vue en perspective d'un levier pour glissière selon les figures 2A et 2B;
- la figure 5A est une vue en perspective d'une glissière selon l'invention montée sur une carte électronique, elle-même montée dans une rainure d'un socle pour carte électronique ;
- la figure 5B est une vue en perspective de deux cartes électroniques montées sur un socle dont l'une est en cours de démontage ;
- la figure 6 est une vue en coupe transversale d'une glissière selon l'invention ;
- la figure 7 est une vue en perspective d'un autre mode de réalisation d'une glissière selon l'invention ; et
- la figure 8 est une vue en perspective d'un autre mode de réalisation de glissière montée sur une carte électronique et insérée dans une rainure d'un socle pour carte électroniques.

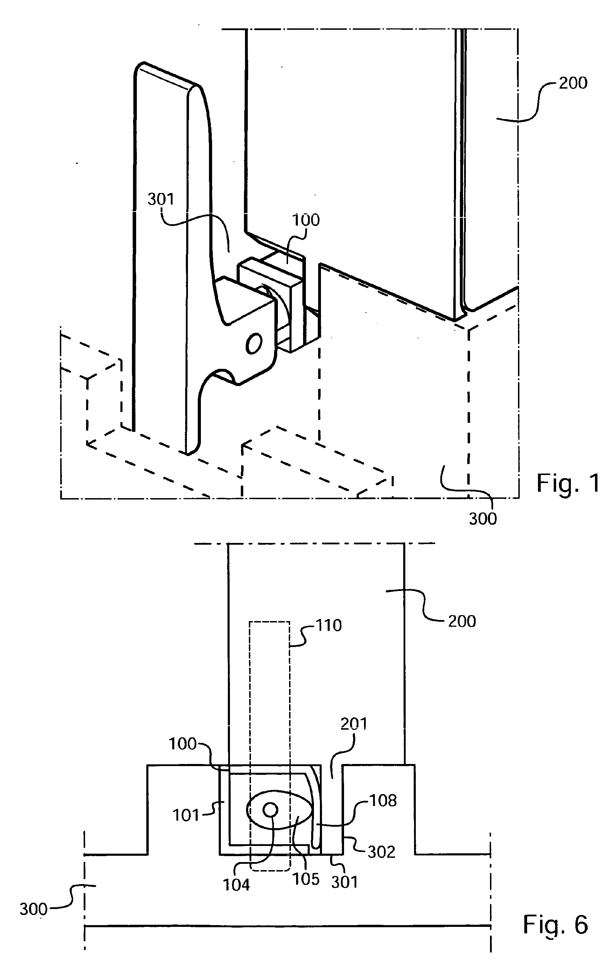

Comme visible en figure 1, une glissière 100 pour carte électronique 200 est montée dans une rainure 301 d'un socle 300 destiné à accueillir une pluralité de cartes électroniques.

La glissière est fixée à la carte électronique par vissage (non représenté).

Le socle 300 est destiné à être monté dans un boitier ou cabinet (non représenté) et peut accueillir plusieurs cartes ou modules électroniques. Chaque carte électronique ou module électronique est monté, suivant l'une de ses tranches, sur une glissière telle que représentée en figure 1. La glissière est elle-même insérée dans une rainure prévue à cet effet dans le socle. Le fond du boitier présente une pluralité de connecteurs disposés perpendiculairement au socle, de manière à raccorder électriquement les cartes électroniques montées sur la glissière par la tranche perpendiculaire et immédiatement voisine de la tranche montée sur la glissière.

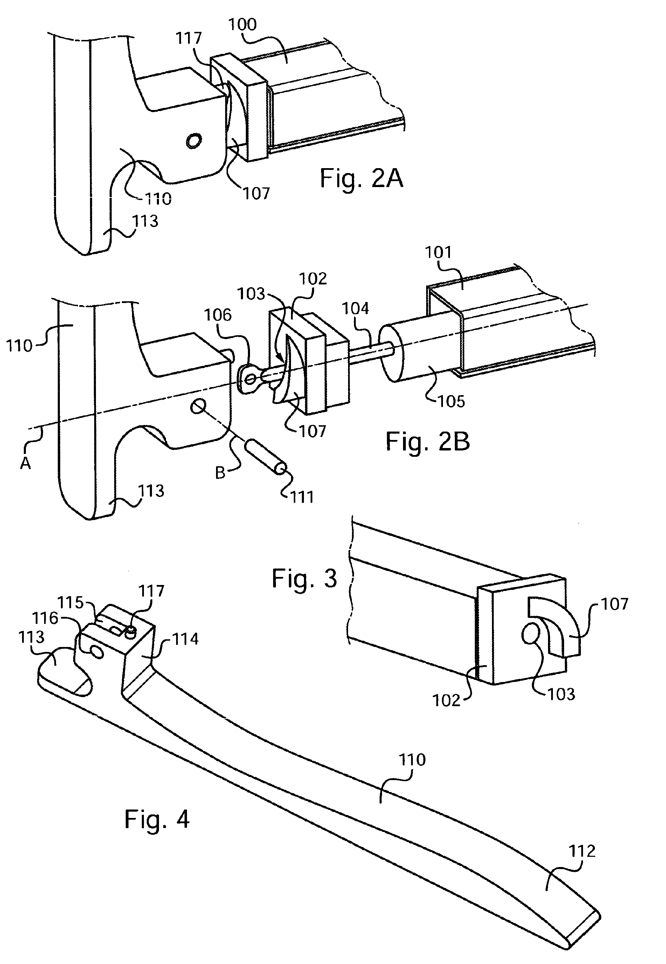

Comme visible plus particulièrement sur les figures 2A et 2B, la glissière 100 présente un corps de glissière 101 fermé par un bouchon 102 dans lequel est pratiquée une ouverture 103 pour le passage d'un arbre 104 présentant un profil de came 105.

L'extrémité de l'arbre présente un pivot 106 destiné à coopérer avec un levier 110 monté en rotation sur le pivot 106 à l'aide d'un pion 111.

Ainsi, le levier d'extraction 110 est monté en rotation sur la glissière autour, d'une part, d'un axe A parallèle à la direction longitudinale de la glissière et, d'autre part, en rotation autour d'un second axe B perpendiculaire au premier axe.

Comme représenté à la figure 4, le levier présente une première extrémité de manipulation 112 et, à son extrémité opposée, une extrémité d'appui 113 formant moyen d'appui sur le socle 300 lorsque la glissière est montée sur celui-ci.

Le levier présente entre ses deux extrémités une portion centrale 114 dans laquelle est pratiquée une fente 115 destinée à loger le pivot 106 de l'arbre 104.

La fente 115 est percée perpendiculairement à sa plus grande dimension d'un trou 116 destiné à accueillir le pion 111 formant le deuxième axe de rotation sensiblement perpendiculaire au premier axe de rotation matérialisé par l'arbre 104.

Le bouchon 102 présente sur sa face extérieure une surface inclinée formant rampe 107 (figures 2 et 3) destinée à coopérer avec un doigt de commande 117 prévu à cet effet en saillie sur la portion centrale 114 du levier 110 (figure 4). La rampe 107 présente une forme circulaire conçue de manière à se trouver sur le chemin du doigt 107 lorsque le levier est entraîné en pivotement autour de l'axe A.

Ainsi, la rampe 107 et le doigt 117 correspondant forment des moyens de commande mécaniques disposés de manière à ce que, lorsque la glissière est montée dans le socle, et que le levier 110 est pivoté par son extrémité de manipulation 112 autour du premier axe A, la rampe 107 coopérant avec le doigt 117 impose au levier 110 une rotation autour de l'axe B matérialisé par le pion 111.

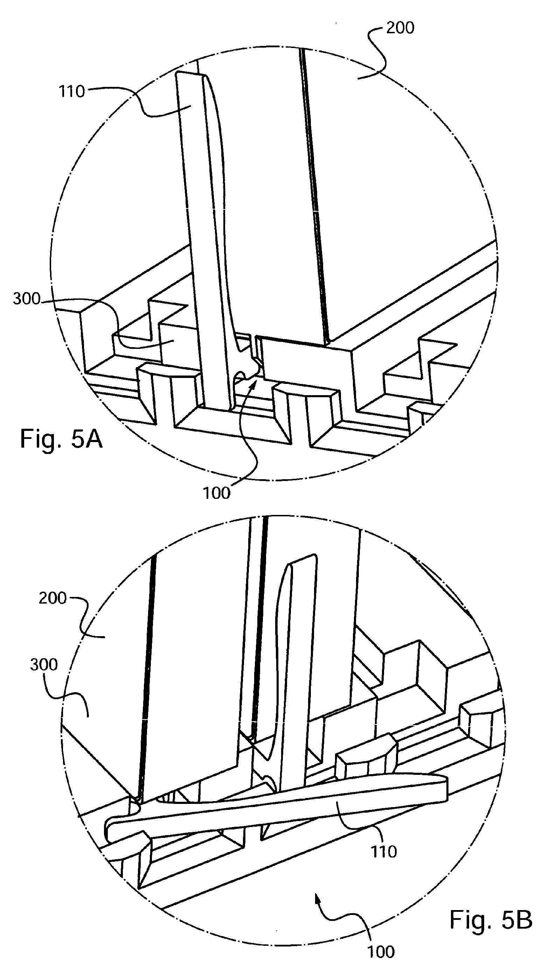

Ceci est plus particulièrement visible sur les figures 5A et 5B sur lesquelles le levier est représenté respectivement dans une position où la glissière est verrouillée, puis dans une position où la glissière est déverrouillée et le retrait de la carte électronique est amorcé.

La rotation du levier autour du premier axe A entraine une rotation de ce même levier autour de l'axe B. L'extrémité d'appui 113 prend alors appui sur le socle 300 et, par son mouvement de rapprochement vers le socle, contribue à dégager la glissière du socle.

La glissière étant fixée sur la carte électronique, ce mouvement de dégagement résulte en une amorce du retrait de la carte électronique des contacts électroniques (non représentés) disposés à l'extrémité opposée de la carte électronique.

Pendant la rotation autour de l'axe A, la glissière 100 est déverrouillée suivant un principe mécanique illustré en figure 6.

L'arbre 104 présente un profil de came 105 coopérant avec une face longitudinale flexible et mobile 108 du corps de glissière 101.

Lorsque la glissière 100 est montée dans le socle 300, comme illustré à la figure 6, le profil de came écarte la face mobile 108 de manière à la plaquer contre une saillie 201 de la carte électronique 200 prévue à cet effet, afin de serrer cette saillie contre une paroi 302 de la rainure 301. Ainsi, la glissière est verrouillée dans le socle.

Lors de la rotation du levier 110 représenté en pointillés sur la figure 6, la came 105 se dégage de la face longitudinale mobile et flexible 108 qui libère à son tour la saillie 201 de la carte 200, ce qui déverrouille la glissière dans la rainure et rend la carte 200 libre en translation.

Ainsi, les actions de déverrouillage et d'amorce de retrait combinées par la double rotation du levier permettent à un opérateur, en une seule manipulation, de déverrouiller la glissière via la came 105 et la paroi 108 et d'amorcer l'extraction de la glissière via la rampe 107 et le doigt 117 d'un seul geste et en une seule opération.

L'extraction se poursuit en faisant ensuite pivoter plus loin le levier autour de l'axe B en éloignant l'extrémité de manipulation de la carte, ce qui rapproche alors l'extrémité d'appui du socle. L'extraction peut être achevée comme avec un extracteur à levier conventionnel : en tirant sur l'extrémité de manipulation, par appui sur le socle, l'extrémité d'appui permet d'extraire la carte par rotation du levier autour de l'axe B.

Suivant un mode de réalisation alternatif non représenté, le doigt est porté par le bouchon de la glissière et c'est la partie centrale du levier qui présente une rampe correspondante.

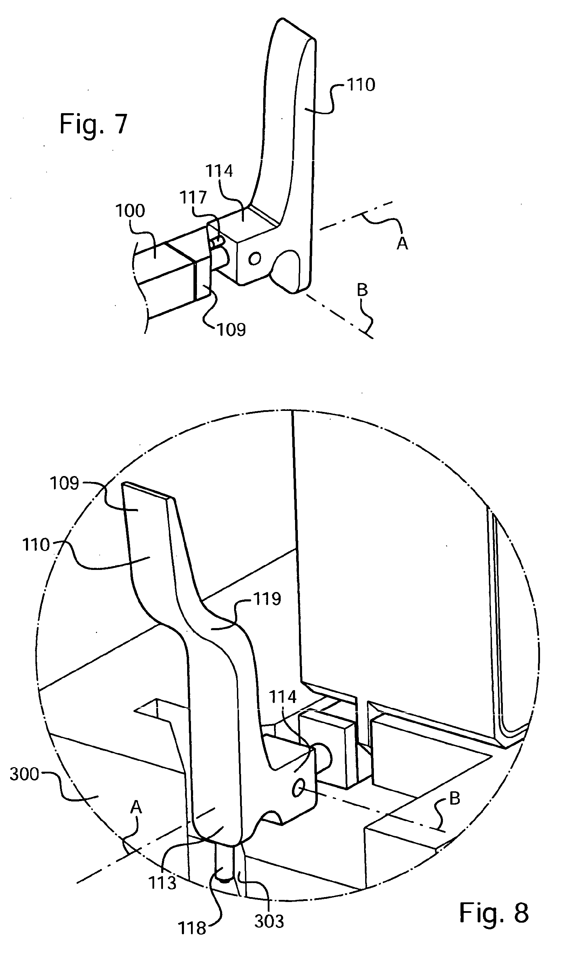

Un autre mode de réalisation est visible en figure 7. Suivant le même principe que décrit précédemment, un doigt 117 est prévu sur la portion centrale 114 du levier 110. Toutefois, la face avant du bouchon 109 est inclinée par rapport à une direction longitudinale de la glissière 100 de manière à constituer une surface inclinée formant rampe afin d'imposer au levier 110 une rotation autour du second axe B lors de sa rotation autour du premier axe A, selon le même principe que décrit précédemment.

Un autre mode de réalisation est représenté en figure 8. Le moyen de commande mécanique, destiné à imposer au levier une rotation autour du second axe lorsque celui-ci pivote autour du premier axe, comporte une surface 303 en profil de came disposée sur le socle 300 et un doigt de commande 118 faisant saillie à partir de la partie centrale 114 du levier 110 perpendiculairement à sa direction longitudinale. Ainsi, le doigt 118 est sensiblement parallèle à l'extrémité d'appui 113 du levier.

Dans un mode de réalisation alternatif non représenté, le doigt est constitué par l'extrémité d'appui du levier elle-même.

Le principe de verrouillage de la glissière par parois élastiques et profil de came est identique au mode de réalisation précédent et ne sera pas décrit plus en détail ici.

Dans le présent mode de réalisation, la fonction de commande mécanique de la seconde rotation par rapport à la première est déplacée au niveau d'une rampe pratiquée directement dans le socle. Comme dans le mode de réalisation précédent, la rotation combinée selon les deux axes du levier permet d'une part, de déverrouiller la glissière et, d'autre part, d'amorcer l'extraction de la carte électronique. L'amorce d'extraction se fait suivant le même principe d'un doigt de commande 118 glissant une surface inclinée 303 de manière à rapprocher l'extrémité 113 d'appui vers le socle pour dégager ainsi la glissière de la rainure. On observera en outre sur la figure 8 que le levier 110 présente dans ce mode de réalisation une portion coudée 119 prévue pour s'éloigner de la carte à l'endroit où est agencée l'extrémité de manipulation 112. Ceci permet au levier de se trouver dégagé de la carte voisine disposée sur le socle lorsque celui-ci complètement a pivoté autour de son premier axe de manière analogue à ce qui est visible en figure 5B. Le dimensionnement de ce coude permet au concepteur du socle et du boîtier électronique d'ajuster les espacements entre les cartes électroniques sans avoir à se soucier de la trajectoire de l'extrémité de manipulation des différentes glissières montées sur le socle. On notera que le levier coudé s'applique à tous les modes de réalisation décrits supra pour ne pas perturber les cartes électroniques avoisinantes.

On notera enfin que l'ensemble des modes de réalisation décrits ici s'applique particulièrement à des applications pour cartes électroniques de dispositifs avioniques d'un aéronef.

## Revendications

1. Glissière (100) pour carte électronique (200) destinée à être montée dans une rainure (301) d'un socle (300) pour carte électronique, comportant un levier (110) d'extraction de glissière monté en rotation sur la glissière autour d'un premier axe (A) sensiblement parallèle à la direction longitudinale de la glissière et en rotation autour d'un second axe (B) sensiblement perpendiculaire au premier axe, le levier comportant :
- une extrémité de manipulation (112) et, à son extrémité opposée,
- une extrémité d'appui (113) présentant un moyen d'appui sur le socle, les deux extrémités étant disposées de part et d'autre du second axe de rotation B,
**caractérisée en ce que** la glissière comporte un moyen de commande mécanique (117, 107) disposé de manière à ce que, lorsque la glissière est montée dans le socle, et que le levier (110) est entraîné en pivotement par son extrémité de manipulation autour du premier axe A, le moyen de commande impose au levier une rotation autour du second axe B de manière à éloigner l'extrémité de manipulation (112) du socle (300) et à rapprocher l'extrémité d'appui (113) du socle (300) afin que cette extrémité prenne appui sur le socle et, par son mouvement de rapprochement contribue à dégager la glissière du socle.

2. Glissière selon la revendication 1, **caractérisée en ce que** le premier axe de rotation est matérialisé par un arbre (104) présentant un profil de came (105) monté longitudinalement dans la glissière (100), la glissière présentant une face longitudinale mobile (108) destinée à coopérer avec le profil de came de l'arbre de manière à ce que, lorsque la glissière (100) est montée dans le socle (300), la profil de came écarte la face longitudinale mobile de façon à verrouiller la glissière dans la rainure (301) du socle dans laquelle elle est montée et, lors d'une rotation du levier autour du premier axe A, l'arbre tourne sur lui-même de manière à dégager le profil de came et libérer la face mobile pour déverrouiller la glissière dans la rainure.

3. Glissière selon la revendication 2, **caractérisée en ce que** le moyen de commande comporte entre le levier (110) et la glissière (100) une surface inclinée (107) formant rampe et un doigt (117) de commande glissant sur ladite surface de manière à imposer au levier ladite rotation autour du second axe afin d'éloigner l'extrémité de manipulation (112) du socle lorsque le levier est entraîné en pivotement par son extrémité de manipulation autour du premier axe A.

4. Glissière selon la revendication 3, **caractérisée en ce qu'**elle présente une face avant en regard du levier (110), la rampe (107) étant disposée sur ladite face, le doigt (117) étant disposé sur le levier sensiblement en regard de cette face, et la rampe (107) étant circulaire de manière à se trouver sur le chemin du doigt lorsque le levier est entraîné en pivotement autour du premier axe.

5. Glissière selon la revendication 3, **caractérisée en ce que** ladite face avant de la glissière (100) est inclinée par rapport à la direction longitudinale de la glissière de manière à constituer ladite surface inclinée (107) formant rampe.

6. Glissière selon l'une quelconque des revendications 1 à 5, **caractérisée en ce que** le levier d'extraction (110) est coudé (119) pour s'éloigner de la carte (200) à son extrémité de manipulation de manière à se trouver dégagé de la carte voisine sur le socle lorsqu'il a pivoté.

7. Glissière selon la revendication 1 ou 2, **caractérisée en ce que** le moyen de commande comporte une surface (303) en profil de came disposée sur le socle (300) et un doigt (118) de commande disposé sur le levier (110), le doigt glissant sur ladite surface de manière à imposer au levier ladite rotation autour du second axe de manière à éloigner l'extrémité de manipulation du socle lorsque le levier est entraîné en pivotement par son extrémité de manipulation autour du premier axe.

8. Glissière selon la revendication précédente, **caractérisée en ce que** le doigt de commande (118) est l'extrémité d'appui du levier (113).

9. Socle (300) pour une carte électronique montée sur une glissière (100) selon l'une des revendications 7 ou 8.

10. Aéronef **caractérisé en ce qu'**il comporte un boitier de cartes électroniques comportant au moins une glissière (110) selon l'une des revendications 1 à 8.

## Patentansprüche

1. Gleitführung (100) für elektronische Karten (200), die dazu bestimmt ist, in einen Schlitz (301) eines Aufnahmesockels (300) für elektronische Karten montiert zu werden, enthaltend einen Hebel (110) zum Herausziehen der Gleitführung, der an der Gleitführung um eine erste Achse (A), die im wesentlichen parallel zur Längsrichtung der Gleitführung verläuft, und um eine zweite Achse (B), die im wesentlichen senkrecht zur ersten Achse verläuft, drehbar gelagert ist, wobei der Hebel aufweist:
- einen Handhabungsendabschnitt (112) und an seinem entgegengesetzten Ende
- einen Abstützendabschnitt (113), der ein Mittel zum Abstützen an dem Sockel aufweist, wobei die beiden Endabschnitte beiderseits der zweiten Drehachse B angeordnet sind,
**dadurch gekennzeichnet, dass** die Gleitführung ein mechanisches Steuermittel (117, 107) aufweist, das so angeordnet ist, dass dann, wenn die Gleitführung im Sockel montiert ist und der Hebel (110) mit seinem Handhabungsendabschnitt um die erste Achse A herum verschwenkt wird, das Steuermittel den Hebel mit einer Drehung um die zweite Achse B beaufschlagt, so dass der Handhabungsendabschnitt (112) sich vom Sockel (300) entfernt und der Abstützendabschnitt (113) sich dem Sockel (300) annähert, damit dieser Endabschnitt in Abstützung an diesen Sockel gelangt und mit seiner Annäherungsbewegung dazu beiträgt, die Gleitführung aus dem Sockel freizugeben.

2. Gleitführung nach Anspruch 1,
**dadurch gekennzeichnet, dass** die erste Drehachse von einer Welle (104) mit einem Steuerkurvenprofil (105) gebildet wird, die longitudinal in der Gleitführung (100) gelagert ist, wobei die Gleitführung eine bewegliche Längsseite (108) aufweist, die dazu bestimmt ist, mit dem Steuerkurvenprofil der Welle so zusammenzuwirken, dass dann, wenn die Gleitführung (100) in dem Sockel (300) montiert ist, das Steuerkurvenprofil die bewegliche Längsseite wegrückt, so dass die Gleitführung in dem Schlitz (301) des Sockels, in welchem sie montiert ist, verriegelt wird, und dass bei einer Drehung des Hebels um die erste Achse A herum die Welle sich um sich selbst dreht, so dass das Steuerkurvenprofil freigelegt wird und die bewegliche Seite freigegeben wird, um die Gleitführung in dem Schlitz zu entriegeln.

3. Gleitführung nach Anspruch 2,
**dadurch gekennzeichnet, dass** das Steuermittel zwischen dem Hebel (110) und der Gleitführung (100) eine geneigt verlaufende, rampenartige Fläche (107) und einen Steuerfinger (117) aufweist, der an der Fläche so gleitet, dass der Hebel mit der Drehung um die zweite Achse beaufschlagt wird, um den Handhabungsendabschnitt (112) vom Sockel dann zu entfernen, wenn der Hebel mit seinem Handhabungsendabschnitt um die erste Achse A herum verschwenkt wird.

4. Gleitführung nach Anspruch 3,
**dadurch gekennzeichnet, dass** sie eine dem Hebel (110) gegenüberliegende Vorderseite aufweist, wobei die Rampe (107) an der genannten Seite angeordnet ist, wobei der Finger (117) an dem Hebel im Wesentlichen dieser Seite gegenüberliegend angeordnet ist und wobei die Rampe (107) rund ausgeführt ist, so dass sie sich auf dem Verlagerungsweg des Fingers befindet, wenn der Hebel um die erste Achse herum verschwenkt wird.

5. Gleitführung nach Anspruch 3,
**dadurch gekennzeichnet, dass** die Vorderseite der Gleitführung (100) bezüglich der Längsrichtung der Gleitführung geneigt verläuft, so dass sie die geneigt verlaufende, rampenartige Fläche (107) bildet.

6. Gleitführung nach einem der Ansprüche 1 bis 5,
**dadurch gekennzeichnet, dass** der Auszugshebel (110) gekrümmt ist (119), um sich mit seinem Handhabungsendabschnitt von der Karte (200) zu entfernen, so dass er von der benachbarten Karte am Sockel freigegeben ist, wenn er verschwenkt ist.

7. Gleitführung nach Anspruch 1 oder 2,
**dadurch gekennzeichnet, dass** das Steuermittel eine Fläche (303) mit Steuerkurvenprofil aufweist, die an dem Sockel (300) angeordnet ist, sowie einen Steuerfinger (118), der an dem Hebel (110) angeordnet ist, wobei der Finger auf der Fläche so gleitet, dass der Hebel mit der Drehung um die zweite Achse beaufschlagt wird, so dass der Handhabungsendabschnitt sich vom Sockel dann entfernt, wenn der Hebel mit seinem Handhabungsendabschnitt um die erste Achse herum verschwenkt wird.

8. Gleitführung nach dem vorangehenden Anspruch,
**dadurch gekennzeichnet, dass** der Steuerfinger (118) der Abstützendabschnitt des Hebels (113) ist.

9. Aufnahmesockel (300) für eine elektronische Karte, die in einer Gleitführung (100) nach einem der Ansprüche 7 oder 8 montiert ist.

10. Luftfahrzeug,
**dadurch gekennzeichnet, dass** es ein Aufnahmegehäuse für elektronische Karten aufweist, das zumindest eine Gleitführung (110) nach einem der Ansprüche 1 bis 8 umfasst.

## Claims

1. A slide (100) for an electronic card (200) adapted to be mounted in a groove (301) of a base (300) for an electronic card, comprising a slide extraction lever (110) rotatably mounted on the slide around a first axis (A) substantially parallel to the longitudinal direction of the slide and rotatably mounted around a second axis (B) substantially perpendicular to the first axis, the lever comprising:
- an end (112) for handling, and, at its opposite end,
- a bearing end (113) having a means for bearing on the base, the two ends being disposed on respective opposite sides of the second rotational axis B,
**characterized in that** the slide comprises a mechanical actuating means (117, 107) disposed such that, when the slide is mounted in the base, and the lever (110) is pivotally driven by its manipulation end around the first axis A, the actuating means imparts to the lever a rotation around the second axis B so as to move the handling end (112) away from the base (300) and to approach bearing end (113) towards the base (300), in order for the bearing end to bear on the base and, by its approaching movement to contribute to disengaging the slide from the base.

2. A slide according to claim 1, **characterized in that** the first rotational axis is materialized by a spindle (104) having a cam formation (105) longitudinally mounted in the slide (100), the slide having a movable longitudinal face (108) adapted to cooperate with the cam formation of the spindle such that, when the slide (100) is mounted in the base (300), the cam formation moves the movable longitudinal face away so as to lock the slide in the groove (301) of the base in which it is mounted and, when the lever is rotated around the first axis A, the spindle turns on itself so as to disengage the cam formation and free the movable face to unlock the slide in the groove.

3. A slide according to claim 2, **characterized in that** the actuating means comprises between the lever (110) and the slide (100) an inclined surface (107) forming a ramp and an actuating finger (117) sliding on said surface so as to impart to the lever said rotation around the second axis in order to move the handling end (112) away from the base when the lever is pivotally driven by its handling end around the first shaft A.

4. A slide according to claim 3, **characterized in that** it has a front face facing the lever (110), the ramp (107) being disposed on said face, the finger (117) being disposed on the lever substantially facing said face, and the ramp (107) being circular so as to be located on the path of the finger when the lever is pivoted about the first axis.

5. A slide according to claim 3, **characterized in that** said front face of the slide (100) is inclined relative to the longitudinal direction of the slide so as to constitute said inclined ramp-forming surface (107).

6. A slide according to any one of claims 1 to 5, **characterized in that** the extraction lever (110) is bent (119) in order to be spaced away from the card (200) at its handling end so as to be located clear of the neighboring card on the base when it has pivoted.

7. A slide according to claim 1 or 2, **characterized in that** the actuating means comprises a cam surface (303) disposed on the base (300) and an actuating finger (118) disposed on the lever, the finger sliding on said surface so as to impart to the lever said rotation around the second axis in order to move the handling end away from the base when the lever is pivotally driven by its handling end around the first shaft.

8. A slide according to the preceding claim, **characterized in that** the actuating finger (118) is the bearing end of the lever (113).

9. A base (300) for an electronic card mounted on a slide (100) according to one of claims 7 or 8.

10. An aircraft **characterized in that** it comprises a casing for electronic cards comprising at least one slide (110) according to one of claims 1 to 8.
